# EUROPÄISCHE PATENTSCHRIFT

(11) **EP 3 381 055 B1**
(45) Veröffentlichungstag und Bekanntmachung des Hinweises auf die Patenterteilung: **11.12.2019**
(21) Anmeldenummer: 16782226.1
(22) Anmeldetag: 17.10.2016
(51) Int. Cl.: H01L 25/07

(54) **LEISTUNGSMODUL FÜR EINEN ELEKTROMOTOR**
POWER MODULE FOR AN ELECTRIC MOTOR
MODULE DE PUISSANCE DESTINÉ À UN MOTEUR ÉLECTRIQUE

(30) Priorität: 27.11.2015 DE 102015223599
(43) Veröffentlichungstag der Anmeldung: 03.10.2018
(73) Patentinhaber: Robert Bosch GmbH, 70442 Stuttgart (DE)
(72) Erfinder: JOOS, Joachim, 70499 Stuttgart (DE); VON EMDEN, Walter, 72800 Enigen Unter Achalm (DE)
(86) Internationale Anmeldenummer: PCT/EP2016/074894
(87) Internationale Veröffentlichungsnummer: WO 2017/089029

(56) Entgegenhaltungen:
- EP-A1- 2 546 874
- EP-A2- 2 477 222

## Beschreibung

### Stand der Technik

Die Erfindung betrifft ein Leistungsmodul für einen Elektromotor. Das Leistungsmodul weist wenigstens eine Halbleiterschalter-Halbbrücke auf.

Ein solches Modul ist zum Beispiel in EP 2 546 874 A1 oder EP 2 477 222 A2 offenbart.

### Offenbarung der Erfindung

Erfindungsgemäß weist die Halbleiterschalter-Halbbrücke einen High-Side-Haltleiterschalter und einen Low-Side-Halbleiterschalter auf, wobei die Halbleiterschalter der Halbleiterschalter-Halbbrücke jeweils durch einen insbesondere flach ausgebildeten Oberflächenbereich des Halbleiterschalters gebildete Schaltstreckenanschlüsse aufweisen. Die Schaltstreckenanschlüsse, insbesondere ein Normalenvektor des Schaltstreckenanschlusses, weisen jeweils in dieselbe Richtung. Der High-Side-Halbleiterschalter und der Low-Side-Halbleiterschalter schließen einen Schaltungsträger mit wenigstens zwei elektrisch leitfähigen Schichten zwischeneinander ein, wobei der Schaltungsträger wenigstens eine elektrisch isolierende Schicht, insbesondere Substratschicht, und die wenigstens zwei die elektrisch isolierende Schicht zwischeneinander einschließende elektrisch leitfähige Schichten umfasst.

Mittels des Schaltungsträgers sind ein Schaltstreckenanschluss des Low-Side-Halbleiterschalters und ein Schaltstreckenanschluss des High-Side-Halbleiterschalters der Halbbrücke elektrisch miteinander verbunden. Bevorzugt ist durch wenigstens eine oder nur eine elektrisch leitfähige Schicht ein Ausgangsanschluss der Halbleiterschalter-Halbbrücke gebildet.

Durch einen solchen Aufbau kann vorteilhaft ein kompaktes Leistungsmodul bereitgestellt sein. Das Leistungsmodul kann so in einem Elektromotor oder einer elektrischen Maschine platzsparend angeordnet sein.

In einer anderen Variante sind zwei elektrisch leitfähige Schichten mittels wenigstens einer elektrischen Durchkontaktierung miteinander verbunden und bilden gemeinsam einen Ausgangsanschluss der Halbleiterschalter-Halbbrücke, im Folgenden auch Halbbrücke genannt.

In einer bevorzugten Ausführungsform des Leistungsmoduls liegen die Schaltstreckenanschlüsse der Halbleiterschalter einer Halbbrücke einander gegenüber. Bevorzugt sind die Schaltstreckenanschlüsse eines Halbleiterschalters einander koplanar angeordnet. Die Schaltstreckenanschlüsse, welche mittels der elektrisch leitfähigen Schicht miteinander verbunden sind, können so den Schaltungsträger mit den elektrisch leitfähigen Schichten - insbesondere nach Art eines Sandwiches - zwischeneinander einschließen. So kann das Leistungsmodul vorteilhaft platzsparend aufgebaut sein. In einer bevorzugten Ausführungsform ist das Leistungsmodul zur mehrphasigen Schaltung, insbesondere Schaltung von Motorströmen, ausgebildet und weist für jede Phase wenigstens eine oder nur eine Halbleiterschalter-Halbbrücke auf. Das Leistungsmodul kann so beispielsweise zur Ansteuerung eines dreiphasigen Motors drei Halbleiterschalter-Halbbrücken aufweisen. Jede Halbleiterschalter-Halbbrücke kann beispielsweise eine Mehrzahl oder eine Vielzahl von Einzelhalbleiterschalter-Halbbrücken aufweisen, welche zueinander parallel geschaltet sind, insbesondere als Strang angeordnet sind.

Die Halbleiterschalter-Halbbrücke weist bevorzugt für jeden Schaltstreckenanschluss wenigstens zwei, drei oder vier, oder mehr als vier Oberflächenbereiche auf, welche elektrisch leitfähig ausgebildet sind und mit dem Schaltstreckenanschluss verbunden sind. Die Oberflächenbereiche können so jeweils ein Kontakt-Pad bilden.

In einer bevorzugten Ausführungsform des Leistungsmoduls weist die elektrisch leitfähige Schicht eine Phasenstromschiene auf, an die in einer flachen Erstreckung der Schicht wenigstens ein von der Phasenstromschiene quer oder mit einer Querkomponente abweisender Kontaktfinger angeformt ist. Der Kontaktfinger verbindet bevorzugt die mit dem Ausgangsanschluss verbundenen Schaltstreckenanschlüsse der Halbleiterschalter miteinander. Die Kontaktschiene kann so vorteilhaft eine Sammelschiene bilden, welche die von den Kontaktfingern abgeführten Ströme bündelt, oder welche einen Strom auf die Kontaktfinger verteilt, wobei der verteilte Strom mittels der Kontaktfinger zu den Schaltstreckenanschlüssen geführt werden kann.

Weiter vorteilhaft kann die Stromschiene aus einem Leistungsmodul, welches beispielsweise durch ein Mold-Modul gebildet ist, aus einem Moldkörper des Mold-Moduls herausragen, und so von außen elektrisch kontaktiert werden.

In einer bevorzugten Ausführungsform sind die Halbleiterschalter jeweils durch einen Feldeffekttransistor gebildet, wobei der mit dem Ausgangsanschluss der Halbbrücke verbundene Schaltstreckenanschluss des High-Side-Halbleiterschalters ein Source-Anschluss ist, und der mit dem Ausgangsanschluss der Halbbrücke verbundene Schaltstreckenanschluss des Low-Side-Halbleiterschalters ein Drain-Anschluss ist. So kann eine Halbleiterschalter-Halbbrücke, gebildet aus zwei MOS-Feldeffekttransistoren, oder MIS-Feldeffekttransistoren, vorteilhaft kompakt und platzsparend aufgebaut sein. Weiter vorteilhaft kann durch den kompakten Aufbau das Leistungsmodul eine geringe Eigeninduktivität aufweisen.

In einer bevorzugten Ausführungsform sind die Halbleiterschalter jeweils durch einen IGBT (IGBT = Insulated-Gate-Bipolar-Transistor) gebildet, wobei der mit dem Ausgangsanschluss der Halbbrücke verbundene Schaltstreckenanschluss des High-Side-Halbleiterschalters ein Emitter-Anschluss ist und der mit dem Ausgangsanschluss der Halbbrücke verbundene Schaltstreckenanschluss des Low-Side-Halbleiterschalters ein Kollektor-Anschluss ist. Die Halbbrücke kann so - bestehend aus IGBT-Transistoren - vorteilhaft platzsparend aufgebaut sein.

In einer bevorzugten Ausführungsform umfasst der Kontaktfinger zwei zueinander parallel angeordnete elektrisch leitfähige Schichten, welche durch eine elektrisch isolierende Isolierschicht voneinander getrennt sind. Die Schichten des Kontaktfingers kontaktieren bevorzugt einander gegenüberliegende Anschlüsse zueinander verschiedener Halbleiterschalter. So kann vorteilhaft aus dem Zwischenraum, welcher sich zwischen dem Low-Side-Halbleiterschalter und dem High-Side-Halbleiterschalter erstreckt, platzsparend und niederinduktiv die Halbbrücke, insbesondere die Halbleiterschalter der Halbbrücke, mit Spannung versorgt werden.

Der Schaltungsträger ist bevorzugt durch eine Leiterplatte gebildet. Bevorzugt ist die elektrisch isolierende Isolierschicht durch eine faserverstärkte Epoxidharzschicht, insbesondere Prepreg-Schicht gebildet. Die Fasern der faserverstärkten Schicht sind bevorzugt Glasfasern.

Die elektrisch leitfähige Schicht ist bevorzugt durch eine Kupferschicht oder Aluminiumschicht gebildet. Dadurch kann der Schaltungsträger vorteilhaft eine gute elektrische Leitfähigkeit aufweisen.

In einer anderen Ausführungsform ist der Schaltungsträger ein insbesondere gesinterter keramischer Schaltungsträger mit wenigstens einer keramischen Isolierschicht. Der keramische Schaltungsträger ist bevorzugt ein LTCC-Schaltungsträger (LTCC = Low-Temperature-Cofired-Ceramics) oder ein HTCC-Schaltungsträger (HTCC = High-Temperature-Cofired-Ceramics),
DBC-Schaltungsträger (DBC = Direct-Bonded-Copper, auch DCB genannt), AMB-Schaltungsträger (AMB = Active-Metal-Braze), umfassend eine Keramikschicht und wenigstens eine Kupferschicht und/oder wenigstens eine Aluminiumschicht als elektrisch leitfähige Schicht.

Auf diese Weise kann der Schaltungsträger, insbesondere Leiterplatte oder keramischer Schaltungsträger mit wenigstens zwei elektrisch leitfähigen Schichten die Halbleiterschalter als Verbindungsschicht miteinander elektrisch verbinden und so ein kompaktes Leistungsmodul als Halbleiteranordnung ausbilden. Weiter bevorzugt können weitere elektronische Bauelemente in der Leiterplatte integriert sein, beispielsweise Kondensatoren, Widerstände oder Dioden. Bevorzugt sind mittels des Schaltungsträgers Signal- und/oder Steueranschlüsse der Halbleiterschalter-Halbbrücke elektrisch kontaktiert. Durch die einander gegenüberliegenden Anschlüsse der Halbleiterschalter der Halbbrücke kann vorteilhaft eine niederinduktive Halbbrücke ausgebildet sein, da die Verbindungsleitungen zwischen den Halbleiterschaltern kurz ausgebildet sind.

In einer bevorzugten Ausführungsform greifen die Kontaktfinger der Phasenstromschiene und der Stromschiene jeweils ineinander. Auf diese Weise kann die Stromzufuhr und die Stromabfuhr aus dem Leistungsmodul besonders kompakt ausgebildet sein.

Die Erfindung wird nun im Folgenden anhand von Figuren und weiteren Ausführungsbeispielen beschrieben. Weitere vorteilhafte Ausführungsvarianten ergeben sich aus den in den abhängigen Ansprüchen und in den Figuren beschriebenen Merkmalen.
Figur 1 zeigt - schematisch - ein Ausführungsbeispiel für eine Halbleiteranordnung, die eine Halbleiterschalter-Halbbrücke bildet, bei der zwei Halbleiterschalter eine Leiterplatte mit elektrischen Kontakten zur Stromzufuhr und Stromabfuhr zwischeneinander einschließen;
Figur 2 zeigt - schematisch in einer Explosionsdarstellung - eine Halbleiteranordnung in zum Ausbilden von drei Halbleiterschalter-Halbbrücken, gebildet aus FET-Transistoren (FET = Feld-Effekt-Transistor), wobei eine Leiterplatte mit elektrischen Kontakten zur Stromzufuhr und Stromabfuhr zwischen den Low-Side- und den High-Side-Transistoren eingeschlossen sind;
Figur 3 zeigt einen Fertigungsschritt zum Ausbilden eines Leistungsmoduls umfassend die in Figur 2 dargestellten Komponenten, wobei die High-Side-Transistoren mit elektrischen Anschlüssen, insbesondere einer Stromschiene und Ausgangsanschlüssen verlötet werden;
Figur 4 zeigt einen Fertigungsschritt zum Ausbilden eines Leistungsmoduls umfassend die in Figur 3 dargestellten Komponenten, wobei Low-Side-Halbleiterschalter mit elektrischen Anschlüssen, insbesondere der Stromschiene und den Ausgangsanschlüssen verlötet werden;
Figur 5 zeigt einen weiteren Fertigungsschritt zum Ausbilden eines Leistungsmoduls umfassend die in Figur 4 dargestellten Komponenten, wobei die Komponenten in Moldmasse eingebettet werden;
Figur 6 zeigt eine Variante der in Figur 4 dargestellten Halbleiteranordnung, bei der die Halbbrücken ausgangsseitig mit einem Phasentrennschalter verbunden werden;
Figur 7 zeigt einen Fertigungsschritt zum Erzeugen eines Leistungsmoduls mit Phasentrennschaltern, bei dem Low-Side-Halbleiterschalter auf elektrische Anschlüsse aufgelötet werden;
Figur 8 zeigt einen Fertigungsschritt zum Erzeugen eines Leistungsmoduls mit Phasentrennschaltern, bei dem die in Figur 7 gezeigten Komponenten in Moldmasse eingebettet werden.

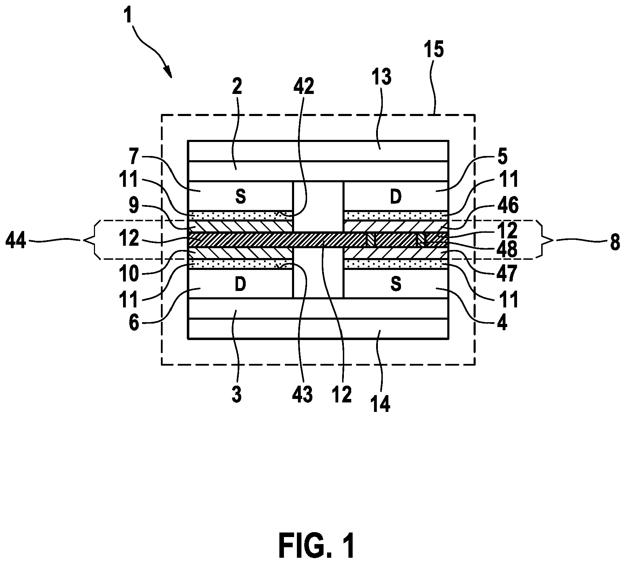

Figur 1 zeigt ein Ausführungsbeispiel für eine Halbleiteranordnung 1. Die Halbleiteranordnung 1 bildet in diesem Ausführungsbeispiel ein Leistungsmodul, das eine Halbleiterschalter-Halbbrücke umfasst. Die Halbleiterschalter-Halbbrücke umfasst in diesem Ausführungsbeispiel einen Low-Side-Halbleiterschalter 2 und einen High-Side-Halbleiterschalter 3. Der Low-Side-Halbleiterschalter 2, welcher in diesem Ausführungsbeispiel durch einen Feldeffekttransistor gebildet ist, weist als Schaltstreckenanschluss einen Source-Anschluss 7 und einen Drain-Anschluss 5 als weiteren Schaltstreckenanschluss auf. Der High-Side-Halbleiterschalter 3 weist als Schaltstreckenanschluss einen Drain-Anschluss 6 und als weiteren Schaltstreckenanschluss einen Source-Anschluss 4 auf. Der Source-Anschluss 4 des High-Side-Halbleiterschalters 3 ist mit dem Drain-Anschluss 5 des Low-Side-Halbleiterschalters elektrisch über einen Abschnitt eines Schaltungsträgers, umfassend eine elektrisch leitfähige Schicht 46, eine elektrisch leitfähige Schicht 47 und eine elektrisch isolierende Substratschicht 12 verbunden. Die Halbleiterschalter 2 und 3 sind jeweils flach ausgebildet. Der Source-Anschluss 7 des Low-Side-Halbleiterschalters 2 weist einen Oberflächenbereich 42 auf, welcher zu einem Oberflächenbereich 43 des Drain-Anschlusses 6 des High-Side-Halbleiterschalters 3 gegenüberliegend angeordnet ist. Der Source-Anschluss 7 und der Drain-Anschluss 5 des Low-Side-Halbleiterschalters 2 erstrecken sich jeweils in einer gemeinsamen Ebene.

Der Drain-Anschluss 5 des Low-Side-Halbleiterschalters 2 und der Source-Anschluss 4 des High-Side-Halbleiterschalters 3 schließen den Leiterplattenabschnitt mit den elektrisch leitfähigen Schichten 46 und 47 zwischeneinander ein. Der Source-Anschluss 4 ist mittels eines elektrischen Verbindungsmittels 11 mit der elektrisch leitfähigen Schicht 47 stoffschlüssig oder materialschlüssig elektrisch verbunden. Der Drain-Anschluss 5 ist mittels eines elektrischen Verbindungsmittels 11 mit der elektrisch leitfähigen Schicht 46 stoffschlüssig oder materialschlüssig elektrisch verbunden. Das Verbindungsmittel 11 ist beispielsweise ein Lotmittel, eine Sinterlotverbindung oder ein elektrisch leitfähiger Klebstoff. Die elektrisch leitfähigen Schichten 46 und 47 sind jeweils mittels einer elektrischen Durchkontaktierung 48, welche die elektrisch isolierende Substratschicht 12 durchtritt, miteinander elektrisch verbunden. Der Leiterplattenabschnitt mit den elektrisch leitfähigen Schichten 46 und 47 bildet einen Ausgangsanschluss 8 der Halbleiteranordnung 1.

Der Source-Anschluss 7 ist in diesem Ausführungsbeispiel mittels eines Verbindungsmittels 11, insbesondere Lotmittel, elektrisch leitfähiger Klebstoff oder Sintermaterial mit einer elektrisch leitfähigen Schicht 9 verbunden. Die elektrisch leitfähige Schicht 9 kann beispielsweise einen Anschluss zur Stromversorgung der Halbleiterschalter-Halbbrücke bilden. Der Drain-Anschluss 6 ist mittels eines Verbindungsmittels 11, insbesondere Lotmittels oder elektrisch leitfähiger Klebstoff oder Sintermaterial mit einer elektrisch leitfähigen Schicht 10 verbunden. Die elektrisch leitfähige Schicht 10 bildet in diesem Ausführungsbeispiel einen weiteren Anschluss zur Stromversorgung der Halbleiterschalter-Halbbrücke. Die elektrisch leitfähigen Schichten 9 und 10 sind in diesem Ausführungsbeispiel parallel und zueinander beabstandet angeordnet und schließen eine elektrisch isolierende Schicht 12, insbesondere faserverstärkte Epoxidharzschicht oder Keramikschicht, zwischeneinander ein. Die elektrisch leitfähigen Schichten 9 und 10 sind so elektrisch voneinander isoliert und bilden gemeinsam mit der Isolierschicht 12 einen Schaltungsträger oder eine Leiterplatte.

Der High-Side-Halbleiterschalter 3 und der Low-Side-Halbleiterschalter 2 schließen die Leiterplatte, gebildet durch die Isolierschicht 12 und die elektrisch leitfähigen Schichten 9, 11, 46 und 47 zwischeneinander ein.

Der Source-Anschluss 7 und der Drain-Anschluss 6 schließen so die elektrisch leitfähigen Schichten 9 und 10 und die - nach Art eines Sandwiches zwischen den elektrisch leitfähigen Schichten 9 und 10 eingeschlossene - elektrisch isolierende Substratschicht 12 zwischeneinander ein. Der Oberflächenbereich 42 des Source-Anschlusses 7 wird so durch die elektrisch leitfähige Schicht 9 elektrisch kontaktiert und der Oberflächenbereich 43 des Drain-Anschlusses 6 wird durch die elektrisch leitfähige Schicht 10 elektrisch kontaktiert. Die elektrisch leitfähigen Schichten 9 und 10 sind beispielsweise nach außen geführt, sodass der Halbleiterschalter so von außen elektrisch kontaktiert werden kann.

Die so gebildete Halbleiterschalter-Halbbrücke, welche kompakt aufgebaut ist, kann in einen Moldkörper 15 eingebettet sein. Der Ausgangsanschluss 8, welcher beispielsweise als elektrisch leitfähige Schicht ausgebildet ist, ragt in diesem Ausführungsbeispiel aus dem Moldkörper 15 heraus. Die elektrisch leitfähige Schicht 9, die elektrisch leitfähige Schicht 10 und die dazwischen eingeschlossene Isolierschicht 12 können zusammen eine Stromschiene 44 oder einen Bestandteil einer Stromschiene bilden und ragen gemeinsam aus dem Moldkörper 15 heraus. Die Halbleiterschalter-Halbbrücke kann so über die Stromschiene 44 mit Strom versorgt werden, wobei der Strom - geschaltet durch den Low-Side-Halbleiterschalter 2 und den High-Side-Halbleiterschalter 3 - über den Ausgangsanschluss 8 ab fließen kann.

Der Low-Side-Halbleiterschalter 2 weist eine nach außen weisende Isolierschicht 13 auf, über die im Halbleiterschalter 2 erzeugte Verlustwärme abgeführt werden kann. Der High-Side-Halbleiterschalter 3 weist eine nach außen weisende Isolierschicht 14 auf, über die im Halbleiterschalter 2 erzeugte Verlustwärme abgeführt werden kann. Die Halbbrücke umfassend die Halbleiterschalter 2 und 3 kann so vorteilhaft über zwei voneinander abweisende Seiten entwärmt werden. Die Isolierschichten 13 und 14 können jeweils durch eine Keramikschicht, DBC-Schicht (DBC = Direct-Bonded-Copper), bei der eine Kupferschicht zum stoffschlüssigen Verbinden, insbesondere Verlöten oder Sintern mit einer Wärmesenke nach außen weist, gebildet sein. An die Isolierschichten 13 und 14, welche beispielsweise durch eine Polyimidschicht gebildet sind, kann eine Wärmesenke, beispielsweise ein Kühlkörper, mittels eines Wärmeleitklebstoffs angekoppelt sein.

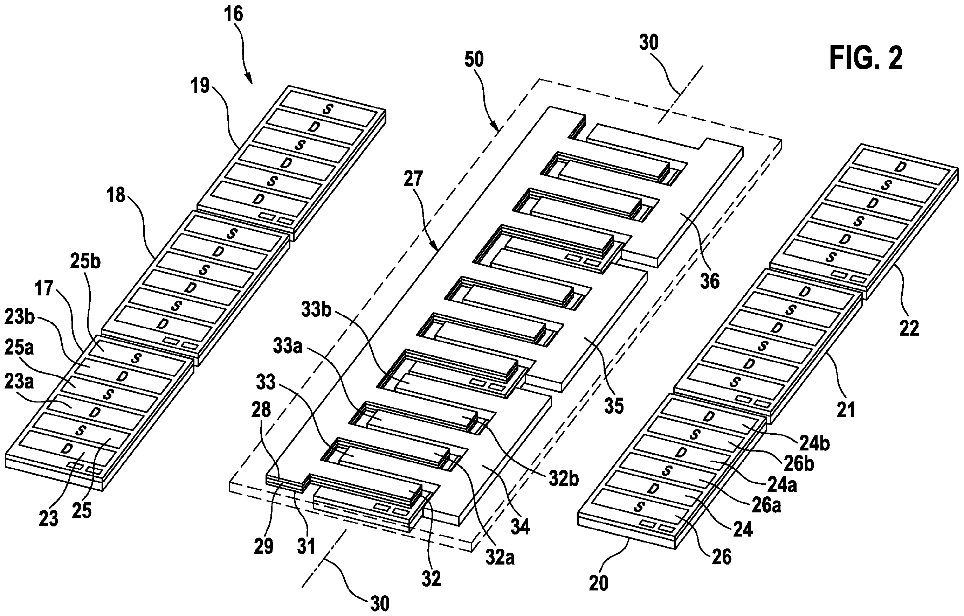

Figur 2 zeigt - schematisch - Bestandteile einer Halbleiteranordnung 16, in einer Explosionsdarstellung. Die Halbleiteranordnung 16 bildet in diesem Ausführungsbeispiel ein Leistungsmodul, welches drei Halbleiterschalter-Halbbrücken zur Ansteuerung eines dreiphasigen Elektromotors oder einer dreiphasigen elektrischen Maschine aufweist. Die Halbleiteranordnung 16 umfasst in diesem Ausführungsbeispiel drei High-Side-Halbleiterschalter, nämlich einen High-Side-Feldeffekttransistor 17, einen High-Side-Feldeffekttransistor 18 und einen High-Side-Feldeffekttransistor 19. Die Feldeffekttransistoren 17, 18 und 19 sind jeweils flach ausgebildet, wobei die Schaltstreckenanschlüsse, insbesondere ein Drain-Anschluss 23, und ein Source-Anschluss 25, jeweils - mit ihrer flachen Erstreckung - in dieselbe Richtung weisen.

Der Drain-Anschluss 23 des Halbleiterschalters 17 ist noch durch zwei weitere Anschlussteile 23a und 23b gebildet. Der Source-Anschluss des Halbleiterschalters 17 umfasst neben dem Source-Anschluss 25 noch zwei weitere Anschlussteile 25a und 25b, welche jeweils durch einen Oberflächenbereich des Halbleiterschalters 17 gebildet sind.

Die Oberflächenbereiche, welche den Source- und den Drain-Anschluss des Halbleiterschalters 17 bilden, wechseln entlang einer Längsachse 30 einander alternierend ab. So ist entlang der Längsachse 30 der Oberflächenbereich, welcher den Source-Anschluss 25 bildet, zu dem Oberflächenbereich, welcher den Drain-Anschluss 23 bildet, benachbart angeordnet. Auf den Oberflächenbereich, welcher den Source-Anschluss 25 bildet, folgt der Oberflächenbereich, welcher den Drain-Anschlussteil 23a bildet. Auf den Drain-Anschlussteil 23a folgt entlang der Längsachse der Source-Anschlussteil 25a und auf den Source-Anschlussteil 25a der Drain-Anschlussteil 23b. Auf den Drain-Anschlussteil 23b folgt der Source-Anschlussteil 25b. So schließen zwei entlang der Längsachse 30 angeordnete Source-Anschlussteile einen Drain-Anschlussteil zwischeneinander ein und entlang der Längsachse 30 angeordnete Drain-Anschlussteile schließen einen Source-Anschlussteil zwischeneinander ein.

Die Halbleiteranordnung 16 umfasst auch einen Schaltungsträger 50, auf dem eine Stromschiene 27 ausgebildet ist. Die Stromschiene 27 umfasst in diesem Ausführungsbeispiel zwei zueinander parallel angeordnete und mittels einer Substratschicht 29 voneinander elektrisch getrennte elektrisch leitfähige Schichten 28 und 31. Die Stromschiene 27 erstreckt sich entlang der Längsachse 30. An die Stromschiene 27 sind entlang der Längsachse 30 zueinander beabstandet Kontaktfinger wie der Kontaktfinger 32 angeformt, wobei die Kontaktfinger jeweils mit den elektrisch leitfähigen Schichten 28 beziehungsweise 31 verbunden sind und die dazwischen angeordnete isolierende Substratschicht 29 zwischeneinander einschließen. Die Stromschiene 27 und die an die Stromschiene 27 angeformten Kontaktfinger bilden somit zwei zueinander parallel angeordnete und mittels der Substratschicht 29 voneinander elektrisch getrennte Kontaktebenen.

Die Substratschicht 29 und/oder die Substratschicht des Schaltungsträgers 50 ist beispielsweise durch eine Prepreg-Schicht, insbesondere faserverstärkte Epoxidharzschicht gebildet.

Die elektrisch leitfähige Schicht 31 des Kontaktfingers 32 ist ausgebildet, mit dem Drain-Anschluss 23 verlötet zu werden. An die Stromschiene 27 sind in diesem Ausführungsbeispiel noch zwei weitere, entlang der Längsachse 30 zueinander beabstandete Kontaktfinger 32a und 32b angeformt. Die elektrisch leitfähige Schicht 31 des Kontaktfingers 32a ist ausgebildet, mit dem Drain-Anschluss 23a elektrisch verbunden, insbesondere verlötet, beispielsweise reflow-verlötet, zu werden. Die elektrisch leitfähige Schicht 31 des Kontaktfingers 32b ist ausgebildet, mit dem Drain-Anschluss 23b verlötet zu werden. Die Stromschiene 27, insbesondere die elektrisch leitfähige Schicht 31 der Stromschiene 27, kann somit mittels der Kontaktfinger 32, 32a und 32b mit dem Drain-Anschluss, insbesondere den Drain-Anschlussteilen 23, 23a und 23b des Halbleiterschalters 17 elektrisch verbunden werden. Der Halbleiterschalter 17 kann so mittels der Stromschiene 27 mit einer elektrischen Spannungsquelle, insbesondere einem Pluspol der Spannungsquelle, elektrisch verbunden werden.

Die Halbleiteranordnung 16 umfasst auch einen Low-Side-Halbleiterschalter 20, welcher ausgebildet ist, mit dem High-Side-Halbleiterschalter 17 gemeinsam eine Halbleiterschalter-Halbbrücke zu bilden. Die Halbleiteranordnung 16 umfasst auch einen Halbleiterschalter 21, welcher ausgebildet ist, gemeinsam mit dem High-Side-Halbleiterschalter 18 eine Halbleiterschalter-Halbbrücke zu bilden und einen weiteren Low-Side-Halbleiterschalter 22, welcher ausgebildet ist, gemeinsam mit dem High-Side-Halbleiterschalter 19 eine Halbleiterschalter-Halbbrücke auszubilden.

Die Halbleiteranordnung 16 umfasst auch einen Ausgangsanschluss 34, welcher in diesem Ausführungsbeispiel als - beispielsweise gestanztes oder lasergeschnittenes - Blechstück, als Inlay in der Substratschicht des Schaltungsträgers 50 ausgebildet ist. Der Ausgangsanschluss 34 umfasst eine sich entlang der Längsachse 30 erstreckende Stromschiene und entlang der Längsachse 30 zueinander beabstandet an die Stromschiene angeformte Kontaktfinger 33, 33a und 33b.

Der Kontaktfinger 33 ist ausgebildet, mit einer flachen Seite mit dem Source-Anschluss 25 des High-Side-Halbleiterschalters 17 verlötet zu werden und mit einer dazu gegenüberliegenden Seite mit einem Drain-Anschluss 24 des Low-Side-Halbleiterschalters 20 verlötet zu werden. Ein zu dem Drain-Anschluss 24 entlang der Längsachse 30 benachbart angeordneter Source-Anschluss 26 des Low-Side-Halbleiterschalters 20 ist ausgebildet, mit der elektrisch leitfähigen Schicht 28 des Kontaktfingers 32 verlötet zu werden, sodass der Source-Anschluss 26 über die Stromschiene 27, insbesondere die elektrisch leitfähige Schicht 28 der Stromschiene 27, mit einem Pol einer Spannungsquelle, insbesondere Minuspol der Spannungsquelle, verbunden werden kann.

Der Kontaktfinger 33a ist ausgebildet, mit dem Source-Anschluss 25a verlötet zu werden und der Kontaktfinger 33b ist ausgebildet, mit dem Source-Anschluss 25b verbunden zu werden.

Der Kontaktfinger 33 des Ausgangsanschlusses 34 verbindet so den Source-Anschluss 25 des High-Side-Halbleiterschalters 17 mit dem Drain-Anschluss 24 des Low-Side-Halbleiterschalters 20 und einen Teilanschluss 24a des Drain-Anschlusses 24 mit dem Teilanschluss 25a des Source-Anschlusses 25. Der Kontaktfinger 33b verbindet den Teilanschluss 24b des Drain-Anschlusses des Low-Side-Halbleiterschalters 20 mit dem Teilanschluss 25b des Source-Anschlusses 25 des High-Side-Halbleiterschalters 17. Die Kontaktfinger 33, 33a und 33b des Ausgangsanschlusses 34 sind somit - nach Art eines Sandwiches - zwischen den sich jeweils flach erstreckenden Halbleiterschaltern, nämlich dem High-Side-Halbleiterschalter 17 und dem Low-Side-Halbleiterschalter 20, eingeschlossen.

An die Stromschiene 27 sind noch weitere Kontaktfinger zum elektrischen Kontaktieren des High-Side-Halbleiterschalters 18 und noch weitere drei Kontaktfinger zum elektrischen Kontaktieren des High-Side-Halbleiterschalters 19 angeformt.

Die Halbleiteranordnung 16 umfasst auch einen Ausgangsanschluss 35 für die Halbleiterschalter-Halbbrücke, umfassend den High-Side-Halbleiterschalter 18 und den Low-Side-Halbleiterschalter 21, und einen Ausgangsanschluss 36 für die Halbbrücke, umfassend den High-Side-Halbleiterschalter 19 und den Low-Side-Halbleiterschalter 22. An die Ausgangsanschlüsse 34, 35 und 36 kann so jeweils eine Phase einer elektrischen Maschine, insbesondere eine Statorspule der elektrischen Maschine, angeschlossen werden.

Die Kontaktfinger der Stromschiene 27 und die Kontaktfinger des Ausgangsanschlusses, wie dem Ausgangsanschluss 34, 35 oder 36, sind jeweils ausgebildet, in einer flachen Erstreckung ineinanderzugreifen. Die Kontaktfinger der Stromschiene und des Ausgangsanschlusses sind so in einer gemeinsamen Ebene angeordnet und können gemeinsam zwischen dem High-Side-Halbleiterschalter 17 und dem Low-Side-Halbleiterschalter 20 - insbesondere nach Art eines Sandwiches - eingeschlossen sein.

Die Halbleiterschalter 17, 18, 19, 20 , 21 und 22 können in einer anderen Ausführungsform jeweils als IGBT ausgebildet sein. Der Source-Anschluss entspricht dann einem Emitteranschluss und der Drain-Anschluss entspricht einem Kollektoranschluss.

Die Halbleiterschalter weisen jeweils - einen in Figur 2 nicht dargestellten - Steueranschluss, insbesondere Gate-Anschluss auf und sind jeweils ausgebildet, an dem Gateanschluss ein Steuersignal zum Durchschalten des Halbleiterschalters zu empfangen und den Halbleierschalter in Abhängigkeit des Steuersignals durchzuschalten oder zu sperren. Der Steueranschluss kann beispielsweise durch einen elektrisch leitfähigen, von den übrigen Bereichen isolierten Bereich der Stromschiene 27 gebildet sein.

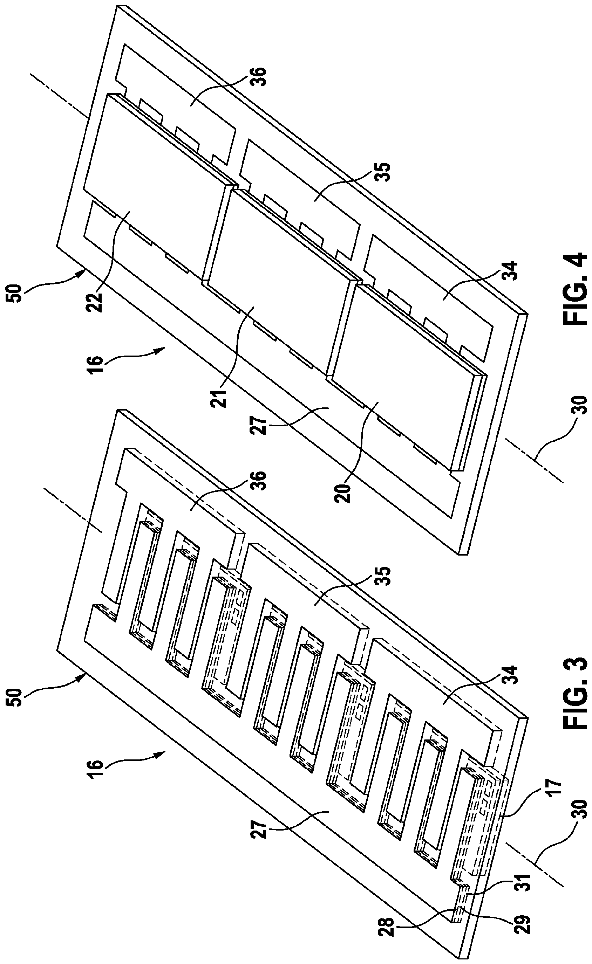

Figur 3 zeigt einen Fertigungsschritt zum Erzeugen eines Leistungsmoduls, umfassend die in Figur 2 bereits dargestellten Teile der in Figur 2 dargestellten Halbleiteranordnung 16. Die Kontaktfinger der Stromschiene 27 werden bei dem in Figur 3 dargestellten Fertigungsschritt mit der elektrisch leitfähigen Schicht 31 auf die Schaltstreckenanschlüsse der High-Side-Halbleiterschalter wie dem Halbleiterschalter 17, dem Halbleiterschalter 18 und dem Halbleiterschalter 19 aufgelegt, und - beispielsweise mittels einer Lotpaste und Reflow-Verlöten - elektrisch und stoffschlüssig verbunden. Die Kontaktfinger des Ausgangsanschlusses 34 werden auf die entsprechenden - wie in Figur 2 bereits beschriebenen - Schaltstreckenanschlüsse des High-Side-Halbleiterschalters 17 gelegt und mit einer Lotpaste - wie in Figur 1 beschrieben - mit den entsprechenden Schaltstreckenanschlüssen verlötet.

In dem selben Schritt wie in Figur 3 dargestellt können der Ausgangsanschluss 35 mit dem High-Side-Halbleiterschalter 18 und der Ausgangsanschluss 36 mit dem High-Side-Halbleiterschalter 19 verlötet werden.

Figur 4 zeigt einen Fertigungsschritt zum Erzeugen des Leistungsmoduls umfassend die in Figur 2 dargestellten Komponenten, bei dem die Low-Side-Halbleiterschalter 20, 21 und 22 auf die Stromschiene 27 und auf die Ausgangsanschlüsse 34, 35 und 36 aufgelegt und mit der Stromschiene 27 und den Ausgangsanschlüssen verlötet werden.

Der Ausgangsanschluss 34 verbindet so den Source-Anschluss des High-Side-Halbleiterschalters 17 mit dem Drain-Anschluss des Low-Side-Halbleiterschalters 20. Die Halbleiterschalter-Halbbrücken umfassend die gemäß Figur 4 zueinander parallel angeordneten Halbleiterschalter, nämlich den High-Side-Halbleiterschalter 17 und den Low-Side-Halbleiterschalter 20, welche gemeinsam eine Halbleiterschalter-Halbbrücke bilden, können so mittels der Stromschiene 27 an eine elektrische Spannungsquelle angeschlossen werden.

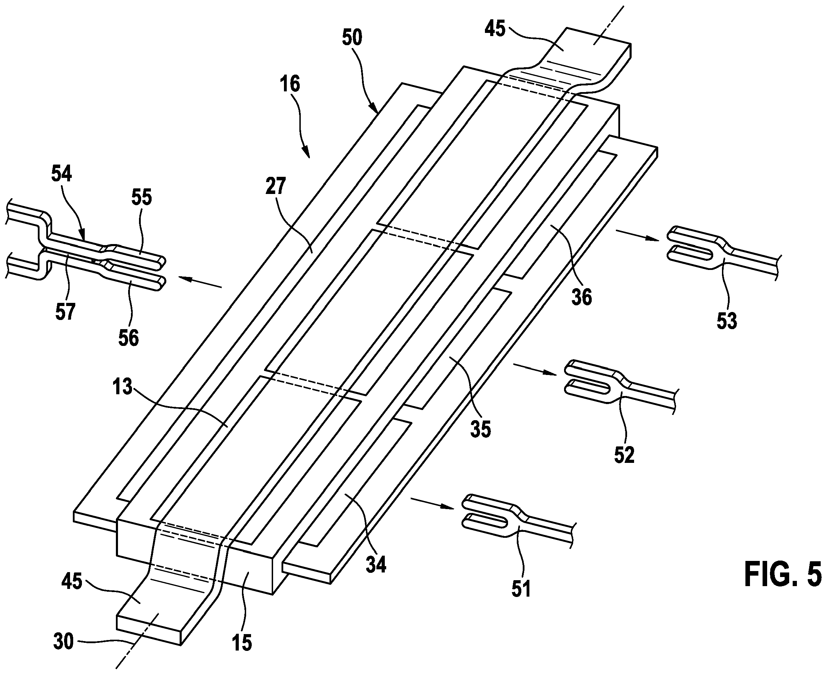

Figur 5 zeigt einen Fertigungsschritt zum Erzeugen des Leistungsmoduls, bei dem die in Figur 4 gezeigte Halbleiteranordnung mittels Moldmasse derart ummoldet wird, dass die Stromschiene 27 und die Ausgangsanschlüsse 34, 35 und 36 aus dem durch die insbesondere auspolymerisierte - Moldmasse gebildeten Moldkörper 15 herausragen.

Figur 5 zeigt auch eine Variante, bei der das Leistungsmodul mit einer Wärmesenke, in diesem Beispiel einem Kühlkörper 45 wärmeleitfähig verbunden ist. Die Isolierschicht 13 ist von dem Kühlkörper, insbesondere Kühlblech wärmeleitfähig kontaktiert, so dass Verlustwärme über den Kühlkörper 45 abgeführt werden kann. Der Kühlkörper 45 kann beispielsweise mit einer Heatpipe verbunden, oder selbst durch eine Heatpipe gebildet sein.

Die Ausgangsanschlüsse 34, 35 und 36 sind gemeinsam als Steckkontakt ausgebildet, so dass das Leistungsmodul in eine Steckleiste eingesteckt werden kann und dort elektrische Kontakte, beispielsweise U-förmig gebildete Kontakte 51, 52 und 53, insbesondere Schneid-Klemmkontakte, kontaktieren kann. Die Stromschiene 27 ist ausgebildet, von einem U- förmigen Kontakt 54 kontaktiert zu werden, welcher eine Kontaktgabel 55 zum Kontaktieren der elektrisch leitfähigen Schicht 28 und eine Kontaktgabel 56 zum Kontaktieren der elektrisch leitfähigen Schicht 31 aufweist. Die Kontaktgabeln 55 und 56 sind mittels eines Isolators 57, beispielsweise Keramik oder Kunststoff, voneinander elektrisch isoliert und ausgebildet, die Stromschiene 27 zu umgreifen. Das Leistungsmodul kann so einfach mit weiteren Komponenten einer elektrischen Maschine steckverbunden werden.

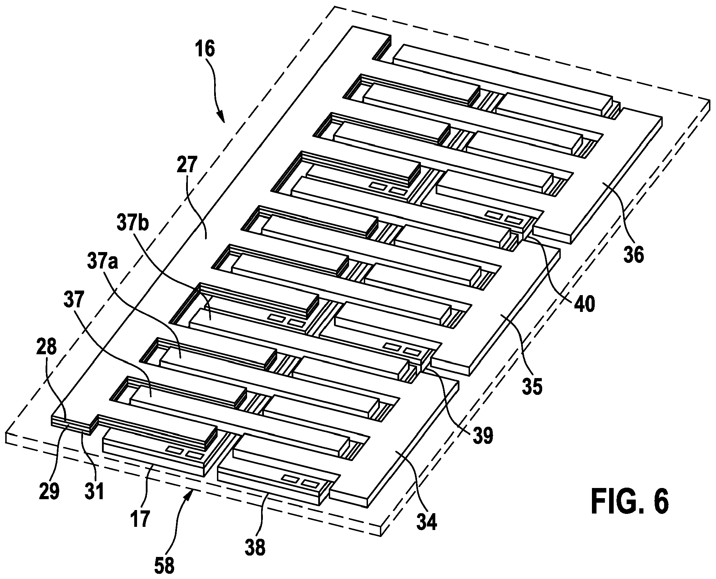

Figur 6 zeigt eine Variante der in den Figuren 2, 3 und 4 dargestellten Halbleiteranordnung, bei der die Halbleiterschalter-Halbbrücken jeweils ausgangsseitig mit einem Phasentrennschalter verbunden sind. Der Phasentrennschalter ist in diesem Ausführungsbeispiel durch einen Feldeffekttransistor, insbesondere entsprechend dem High-Side-Halbleiterschalter 17, ausgebildet.

Die High-Side-Halbleiterschalter wie der Halbleiterschalter 17, 18 und 19 sind jeweils mit ihrer flachen Erstreckung in derselben Ebene angeordnet, wie die Phasentrennschalter, nämlich einem Phasentrennschalter 38, welcher eingangsseitig mit dem Ausgang des High-Side-Halbleiterschalters 17 verbunden ist, einem Phasentrennschalter 39, welcher eingangsseitig mit der Halbbrücke umfassend den High-Side-Halbleiterschalter 18 verbunden ist und einen Phasentrennschalter 40, welcher eingangsseitig mit dem Ausgang der Halbbrücke umfassend den High-Side-Halbleiterschalter 19 und den Low-Side-Halbleiterschalter 22 verbunden ist. Die Halbleiteranordnung 16 umfasst auch einen Schaltungsträger 58, welcher beispielsweise als Isolierschicht 29 eine Prepreg- oder Keramikschicht aufweist.

Die Halbleiteranordnung 16 umfasst zum Verbinden des Phasentrennschalters 38 mit dem High-Side-Halbleiterschalter 17 ein elektrisch leitfähiges Verbindungselement 37, welches in diesem Ausführungsbeispiel als sich längserstreckende Kontaktfinger ausgebildet ist.

Das Verbindungselement 37 ist beispielsweise als insbesondere gestanztes oder lasergeschnittenes Blech, insbesondere Kupferblech, als Inlay im Schaltungsträger 58 gebildet und greift mit einem Endabschnitt zwischen die Kontaktfinger 32 und 32a der Stromschiene 27 und kann so zwischen den Kontaktfingern 32 und 32a den Source-Anschluss 25 elektrisch kontaktieren. Das Verbindungselement 37 kontaktiert so anstelle des Kontaktfingers 33 - in der Halbleiteranordnung 16 in Figur 2 - den Source-Anschluss 25. Ein Endabschnitt des Verbindungselements 37 ist mit einem Schaltstreckenanschluss des Phasentrennschalters 38 lötverbunden, sodass der Source-Anschluss 25 des Halbleiterschalters 17, welcher gemeinsam mit dem Drain-Anschluss 24 des Low-Side-Halbleiterschalters 20 den bereits erwähnten Ausgang der Halbleiterschalterhalbbrücke bildet, mit dem Phasentrennschalter 38 verbunden ist.

Die Halbleiteranordnung 16 umfasst auch den Ausgangsanschluss 34, welcher in der Halbleiteranordnung 16 mit einem Schaltstreckenanschluss des Phasentrennschalters 38 verbunden ist.

Die Halbleiteranordnung 16 umfasst auch ein Verbindungselement 37a, welches sich mit einem Endabschnitt zwischen dem Kontaktfinger 32a und dem Kontaktfinger 32b erstreckt, und ein weiteres Verbindungselement 37b, welches sich zu dem Kontaktfinger 32b benachbart angeordnet erstreckt. Die Verbindungselemente 37, 37a und 37b bilden so einen Ausgang der Halbleiterschalter-Halbbrücke umfassend den High-Side-Halbleiterschalter 17 und den Low-Side-Halbleiterschalter 20 und verbinden diese Halbleiterschalter-Halbbrücke mit dem Phasentrennschalter 38. Die Stromschiene 27 und die Verbindungselemente wie das Verbindungselement 37 und die Ausgangsanschlüsse 34, 35 und 36 sind jeweils in einer gemeinsamen Ebene angeordnet.

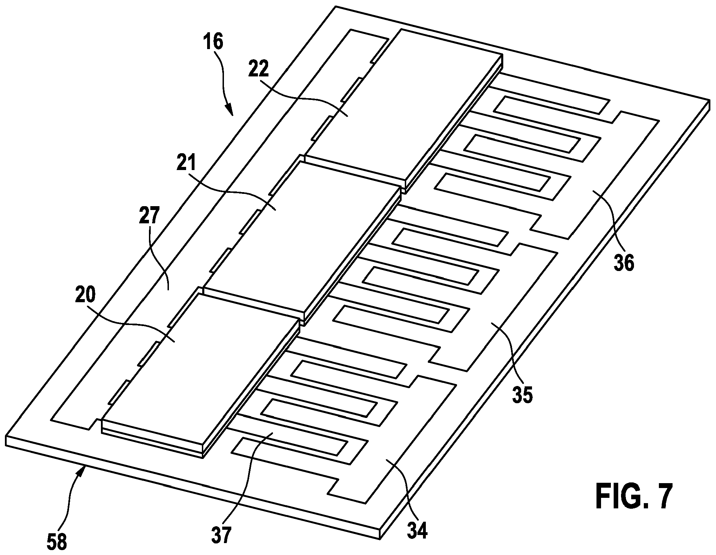

Figur 7 zeigt einen weiteren Fertigungsschritt zum Erzeugen des Leistungsmoduls, umfassend die Halbleiteranordnung 16, bei der in Figur 7 der Low-Side-Halbleiterschalter 20 zu dem High-Side-Halbleiterschalter 17 gegenüberliegend angeordnet ist, der Low-Side-Halbleiterschalter 21 zu dem High-Side-Halbleiterschalter 18 gegenüberliegend angeordnet ist und der Low-Side-Halbleiterschalter 22 zu dem High-Side-Halbleiterschalter 19 gegenüberliegend angeordnet ist. Die Low-Side-Halbleiterschalter 20, 21 und 22 werden jeweils über die Stromschiene 27, insbesondere die elektrisch leitfähige Schicht 28, mit Spannung versorgt, wobei die Drain-Anschlüsse als Ausgangsanschluss mit den Verbindungselementen wie dem Verbindungselement 37 elektrisch verbunden sind. Die Low-Side-Halbleiterschalter 20, 21 und 22 können jeweils mittels Reflow-Löten mit der Stromschiene 27 und mit dem Verbindungselement wie dem Verbindungselement 37 verlötet werden.

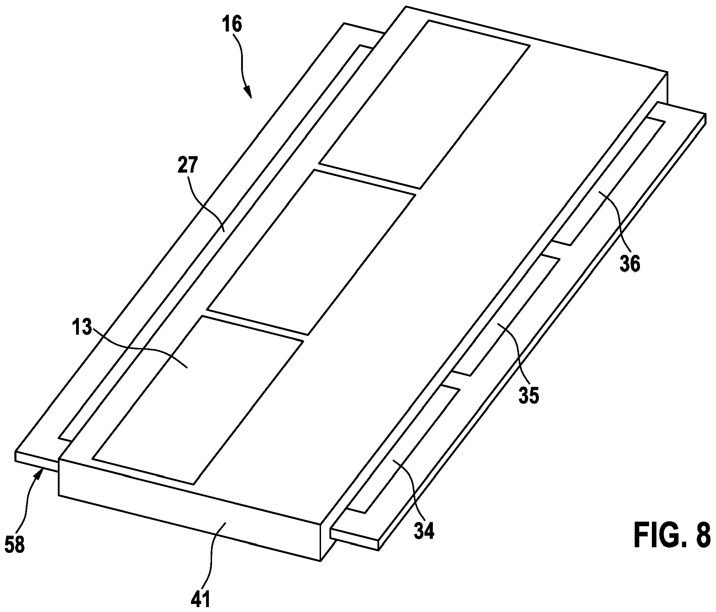

Figur 8 zeigt das Leistungsmodul, bei dem die in Figur 7 gezeigte Halbleiteranordnung 17 mittels einer Moldmasse derart eingebettet ist, dass die Stromschiene 27 und die Ausgangsanschlüsse 34, 35 und 36 aus einem durch die Moldmasse gebildeten Moldkörper 41 herausragen, und dort von einem Steckkontakt klemmend oder zusätzlich schneidend elektrisch kontaktiert werden können.

## Patentansprüche

1. Leistungsmodul (1, 16, 17) für einen Elektromotor, wobei das Leistungsmodul (1, 16, 17) wenigstens eine Halbleiterschalter-Halbbrücke (2, 3, 17, 18, 19, 20, 21, 22) umfasst,
**dadurch gekennzeichnet, dass**
die Halbleiterschalter-Halbrücke (2, 3, 17, 18, 19, 20, 21, 22) einen High-Side-Halbleiterschalter (3, 17, 18, 19) und einen Low-Side-Halbleiterschalter (2, 20, 21, 22) aufweist, wobei die Halbleiterschalter (2, 3, 17, 18, 19, 20, 21, 22) der Halbbrücke (2, 3) jeweils durch einen flach ausgebildeten Oberflächenbereich des Halbleiterschalters (2, 3, 17, 18, 19, 20, 21, 22) gebildete Schaltstreckenanschlüsse (4, 5, 6, 7, 23, 24, 25, 26) aufweisen, und die Schaltstreckenanschlüsse (4, 5, 6, 7, 23, 24, 25, 26) eines Halbleiterschalters jeweils in dieselbe Richtung weisen, wobei der High-Side-Halbleiterschalter (3) und der Low-Side-Halbleiterschalter (2) einen Schaltungsträger mit wenigstens zwei elektrisch leitfähigen Schichten (8, 9, 10, 28, 31, 34, 35, 36) zwischeneinander einschließen, wobei der Schaltungsträger (50, 58) wenigstens eine elektrische Isolierschicht (29) und die wenigstens zwei die Isolierschicht (29) zwischeneinander einschließende elektrisch leitfähige Schichten umfasst, wobei mittels des Schaltungsträgers ein Schaltstreckenanschluss (4, 6, 24, 26) des Low-Side-Halbleiterschalters (2, 20, 21, 22) und ein Schaltstreckenanschluss (5, 7, 23, 25) des High-Side-Halbleiterschalters (3) der Halbbrücke miteinander elektrisch verbunden sind, wobei durch wenigstens eine elektrisch leitfähige Schicht (8, 9, 10) des Schaltungsträgers ein Ausgangsanschluss (8) der Halbleiterschalter-Halbbrücke (2, 3) gebildet ist.

2. Leistungsmodul (1, 16, 17) nach Anspruch 1,
**dadurch gekennzeichnet, dass**
die Schaltstreckenanschlüsse (4, 5, 6, 7, 23, 24, 25, 26) der Halbleiterschalter (2, 3, 17, 18, 19, 20, 21, 22) einer Halbbrücke einender gegenüberliegen.

3. Leistungsmodul (1, 16, 17) nach Anspruch 1 oder 2,
**dadurch gekennzeichnet, dass**
das Leistungsmodul (1, 16, 17) zur mehrphasigen Schaltung ausgebildet ist und für jede Phase wenigstens eine oder nur eine Halbleiterschalter-Halbbrücke aufweist.

4. Leistungsmodul (1, 16, 17) nach einem der vorhergehenden Ansprüche,
**dadurch gekennzeichnet, dass**
die elektrisch leitfähige Schicht (28, 31) eine Phasen-Stromschiene (27) aufweist, an die in einer flachen Erstreckung der Schicht wenigstens ein von der Phasen-Stromschiene (27) quer oder mit einer Querkomponente abweisende Kontaktfinger (33, 33a, 33b) angeformt ist, wobei der Kontaktfinger (33, 33a, 33b) die mit dem Ausgangsanschluss (34, 35, 36) verbundenen Schaltstreckenanschlüsse (24, 25) der Halbleiterschalterschalter (17, 20) miteinander verbindet.

5. Leistungsmodul (1, 16, 17) nach einem der vorhergehenden Ansprüche,
**dadurch gekennzeichnet, dass**
die Halbleiterschalter (2, 3, 17, 18, 19, 20, 21, 22) jeweils durch einen Feldeffekttransistor gebildet sind, wobei der mit dem Ausgangsanschluss der Halbbrücke verbundene Schaltstreckenanschluss des High-Side-Halbleiterschalters ein Source-Anschluss ist und der mit dem Ausgangsanschluss der Halbbrücke verbundene Schaltstreckenanschluss des Low-Side-Halbleiterschalters ein Drain-Anschluss ist.

6. Leistungsmodul (1, 16, 17) nach einem der vorhergehenden Ansprüche 1 bis 4,
**dadurch gekennzeichnet, dass**
die Halbleiterschalter (2, 3, 17, 18, 19, 20, 21, 22) jeweils durch einen IGBT gebildet sind, wobei der mit dem Ausgangsanschluss der Halbbrücke verbundene Schaltstreckenanschluss des High-Side-Halbleiterschalters (2, 3, 17, 18, 19, 20, 21, 22) ein Emitter-Anschluss ist und der mit dem Ausgangsanschluss der Halbbrücke verbundene Schaltstreckenanschluss des Low-Side-Halbleiterschalters ein Kollektor-Anschluss ist.

7. Leistungsmodul (1, 16, 17) nach einem der vorhergehenden Ansprüche,
**dadurch gekennzeichnet, dass**
das Leistungsmodul eine Stromschiene (27) aufweist, an die wenigstens ein Kontaktfinger (32, 32a, 32b) angeformt ist, wobei der Kontaktfinger (32, 32a, 32b) einen Schaltstreckenanschluss zur Stromversorgung der Halbbrücke elektrisch kontaktiert.

8. Leistungsmodul (1, 16, 17) nach Anspruch 7,
**dadurch gekennzeichnet, dass**
durch einen Randabschnitt des Schaltungsträgers ein Steckanschluss gebildet ist, über den das Leistungsmodul elektrisch kontaktiert werden kann.

9. Leistungsmodul (1, 16, 17) nach einem der Ansprüche 7 oder 8,
**dadurch gekennzeichnet, dass**
Kontaktfinger (32, 32a, 32b, 33, 33a, 33b) der Phasen-Stromschine (27) und der Stromschiene des Ausgangsanschlusses (34, 35, 36) jeweils ineinander greifen.

10. Leistungsmodul (1, 16, 17) nach einem der vorhergehenden Ansprüche,
**dadurch gekennzeichnet, dass**
das Leistungsmodul (1, 16, 17) in einen Moldkörper (15, 41) eingebettet ist.

## Claims

1. Power module (1, 16, 17) for an electric motor, wherein the power module (1, 16, 17) comprises at least one semiconductor switch half-bridge (2, 3, 17, 18, 19, 20, 21, 22),
**characterized in that**
the semiconductor switch half-bridge (2, 3, 17, 18, 19, 20, 21, 22) has a high-side semiconductor switch (3, 17, 18, 19) and a low-side semiconductor switch (2, 20, 21, 22), wherein the semiconductor switches (2, 3, 17, 18, 19, 20, 21, 22) of the half-bridge (2, 3) have in each case switching path terminals (4, 5, 6, 7, 23, 24, 25, 26) formed by a surface region of the semiconductor switch (2, 3, 17, 18, 19, 20, 21, 22), said surface region being embodied in a flat fashion, and the switching path terminals (4, 5, 6, 7, 23, 24, 25, 26) of a semiconductor switch in each case face in the same direction, wherein the high-side semiconductor switch (3) and the low-side semiconductor switch (2) enclose between one another a circuit carrier having at least two electrically conductive layers (8, 9, 10, 28, 31, 34, 35, 36), wherein the circuit carrier (50, 58) comprises at least one electrical insulation layer (29) and the at least two electrically conductive layers enclosing the insulation layer (29) between one another, wherein a switching path terminal (4, 6, 24, 26) of the low-side semiconductor switch (2, 20, 21, 22) and a switching path terminal (5, 7, 23, 25) of the high-side semiconductor switch (3) of the half-bridge are electrically connected to one another by means of the circuit carrier, wherein an output terminal (8) of the semiconductor switch half-bridge (2, 3) is formed by at least one electrically conductive layer (8, 9, 10) of the circuit carrier.

2. Power module (1, 16, 17) according to Claim 1,
**characterized in that**
the switching path terminals (4, 5, 6, 7, 23, 24, 25, 26) of the semiconductor switches (2, 3, 17, 18, 19, 20, 21, 22) of a half-bridge are situated opposite one another.

3. Power module (1, 16, 17) according to Claim 1 or 2,
**characterized in that**
the power module (1, 16, 17) is designed for polyphase switching and has at least one or only one semiconductor switch half-bridge for each phase.

4. Power module (1, 16, 17) according to any of the preceding claims,
**characterized in that**
the electrically conductive layer (28, 31) has a phase busbar (27), onto which at least one contact finger (33, 33a, 33b) pointing away from the phase busbar (27) transversely or with a transverse component is integrally formed in a flat extension of the layer, wherein the contact finger (33, 33a, 33b) connects to one another the switching path terminals (24, 25) of the semiconductor switch switches (17, 20) that are connected to the output terminal (34, 35, 36).

5. Power module (1, 16, 17) according to any of the preceding claims,
**characterized in that**
the semiconductor switches (2, 3, 17, 18, 19, 20, 21, 22) are formed in each case by a field effect transistor, wherein that switching path terminal of the high-side semiconductor switch which is connected to the output terminal of the half-bridge is a source terminal and that switching path terminal of the low-side semiconductor switch which is connected to the output terminal of the half-bridge is a drain terminal.

6. Power module (1, 16, 17) according to any of the preceding Claims 1 to 4,
**characterized in that**
the semiconductor switches (2, 3, 17, 18, 19, 20, 21, 22) are formed in each case by an IGBT, wherein that switching path terminal of the high-side semiconductor switch (2, 3, 17, 18, 19, 20, 21, 22) which is connected to the output terminal of the half-bridge is an emitter terminal and that switching path terminal of the low-side semiconductor switch which is connected to the output terminal of the half-bridge is a collector terminal.

7. Power module (1, 16, 17) according to any of the preceding claims,
**characterized in that**
the power module has a busbar (27), onto which at least one contact finger (32, 32a, 32b) is integrally formed, wherein the contact finger (32, 32a, 32b) electrically contacts a switching path terminal for the power supply of the half-bridge.

8. Power module (1, 16, 17) according to Claim 7,
**characterized in that**
a plug connection via which the power module can be electrically contacted is formed by an edge section of the circuit carrier.

9. Power module (1, 16, 17) according to either of Claims 7 and 8,
**characterized in that**
contact fingers (32, 32a, 32b, 33, 33a, 33b) of the phase busbar (27) and of the busbar of the output terminal (34, 35, 36) in each case intermesh.

10. Power module (1, 16, 17) according to any of the preceding claims,
**characterized in that**
the power module (1, 16, 17) is embedded into a moulded body (15, 41).

## Revendications

1. Module de puissance (1, 16, 17) destiné à un moteur électrique, dans lequel le module de puissance (1, 16, 17) comprend au moins un demi-pont de commutateurs semi-conducteurs (2, 3, 17, 18, 19, 20, 21, 22),
**caractérisé en ce que** le demi-pont de commutateurs semi-conducteurs (2, 3, 17, 18, 19, 20, 21, 22) présente un commutateur semi-conducteur High-Side (3, 17, 18, 19) et un commutateur semi-conducteur Low-Side (2, 20, 21, 22), dans lequel les commutateurs semi-conducteurs (2, 3, 17, 18, 19, 20, 21, 22) du demi-pont (2, 3) présentent des raccords de section de commutation (4, 5, 6, 7, 23, 24, 25, 26) respectivement formés par une zone de surface de forme plate du commutateur semi-conducteur (2, 3, 17, 18, 19, 20, 21, 22), et les raccords de section de commutation (4, 5, 6, 7, 23, 24, 25, 26) d'un commutateur semi-conducteur sont orientés respectivement dans la même direction, dans lequel le commutateur semi-conducteur High-Side (3) et le commutateur semi-conducteur Low-Side (2) enferment entre eux un support de circuits avec au moins deux couches électriquement conductrices (8, 9, 10, 28, 31, 34, 35, 36), dans lequel le support de circuits (50, 58) comprend au moins une couche électriquement isolante (29) et lesdites au moins deux couches électriquement conductrices enferment entre elles la couche isolante (29), dans lequel un raccord de section de commutation (4, 6, 24, 26) du commutateur semi-conducteur Low-Side (2, 20, 21, 22) et un raccord de section de commutation (5, 7, 23, 25) du commutateur semi-conducteur High-Side (3) du demi-pont sont électriquement reliés l'un à l'autre au moyen du support de circuits, dans lequel un raccord de sortie (8) du demi-pont de commutateurs semi-conducteurs (2, 3) est formé par au moins une couche électriquement conductrice (8, 9, 10) du support de circuits.

2. Module de puissance (1, 16, 17) selon la revendication 1,
**caractérisé en ce que** les raccords de section de commutation (4, 5, 6, 7, 23, 24, 25, 26) des commutateurs semi-conducteurs (2, 3, 17, 18, 19, 20, 21, 22) d'un demi-pont sont opposés l'un à l'autre.

3. Module de puissance (1, 16, 17) selon une revendication 1 ou 2,
**caractérisé en ce que** le module de puissance (1, 16, 17) est configuré pour un circuit à plusieurs phases et présente pour chaque phase au moins un ou seulement un demi-pont de commutateurs semi-conducteurs.

4. Module de puissance (1, 16, 17) selon l'une quelconque des revendications précédentes,
**caractérisé en ce que** la couche électriquement conductrice (28, 31) présente un rail de contact de phase (27), sur lequel un doigt de contact (33, 33a, 33b) s'écartant transversalement ou avec une composante transversale à partir du rail de contact de phase (27) est formé dans une extension plate de la couche, dans lequel le doigt de contact (33, 33a, 33b) relie l'un à l'autre les raccords de section de commutation (24, 25) des commutateurs des commutateurs semi-conducteurs (17, 20) reliés au raccord de sortie (34, 35, 36).

5. Module de puissance (1, 16, 17) selon l'une quelconque des revendications précédentes,
**caractérisé en ce que** les commutateurs semi-conducteurs (2, 3, 17, 18, 19, 20, 21, 22) sont respectivement formés par un transistor à effet de champ, dans lequel le raccord de section de commutation du commutateur semi-conducteur High-Side relié au raccord de sortie du demi-pont est un raccord source et le raccord de section de commutation du commutateur semi-conducteur Low-Side relié au raccord de sortie du demi-pont est un raccord de drain.

6. Module de puissance (1, 16, 17) selon l'une quelconque des revendications précédentes 1 à 4,
**caractérisé en ce que** les commutateurs semi-conducteurs (2, 3, 17, 18, 19, 20, 21, 22) sont respectivement formés par un IGBT, dans lequel le raccord de section de commutation du commutateur semi-conducteur High-Side (2, 3, 17, 18, 19, 20, 21, 22) relié au raccord de sortie du demi-pont est un raccord d'émetteur et le raccord de section de commutation du commutateur semi-conducteur Low-Side relié au raccord de sortie du demi-pont est un raccord de collecteur.

7. Module de puissance (1, 16, 17) selon l'une quelconque des revendications précédentes,
**caractérisé en ce que** le module de puissance présente un rail de contact (27), sur lequel au moins un doigt de contact (32, 32a, 32b) est formé, dans lequel le doigt de contact (32, 32a, 32b) contacte électriquement un raccord de section de commutation pour l'alimentation électrique du demi-pont.

8. Module de puissance (1, 16, 17) selon la revendication 7,
**caractérisé en ce qu'**un raccord enfichable est formé par une partie de bord du support de circuits, par lequel le module de puissance peut être contacté électriquement.

9. Module de puissance (1, 16, 17) selon une des revendications 7 ou 8,
**caractérisé en ce que** des doigts de contact (32, 32a, 32b, 33, 33a, 33b) du rail de contact de phase (27) et du rail de contact du raccord de sortie (34, 35, 36) s'engagent respectivement l'un dans l'autre.

10. Module de puissance (1, 16, 17) selon l'une quelconque des revendications précédentes,
**caractérisé en ce que** le module de puissance (1, 16, 17) est noyé dans un corps moulé (15, 41).
